# FASCICULE DE BREVET EUROPEEN

(11) **EP 3 422 835 B1**
(45) Date de publication et mention de la délivrance du brevet: **01.01.2020**
(21) Numéro de dépôt: 18180878.3
(22) Date de dépôt: 29.06.2018
(51) Int. Cl.: H05K 7/20

(54) **SYSTEME DE REFROIDISSEMENT D'UN OU PLUSIEURS SERVEURS INFORMATIQUES PAR CALODUCS ET DE PRODUCTION DE CHALEUR A PARTIR DE CELLE RECUPEREE DU (DES) SERVEUR(S)**
SYSTEM ZUR KÜHLUNG EINES ODER MEHRERER IT-SERVER DURCH WÄRMEROHRE UND ZUR ERZEUGUNG VON WÄRME AUS DER VON DEM/DEN SERVER/N GEWONNENEN WÄRME
SYSTEM FOR COOLING ONE OR MORE COMPUTER SERVERS BY HEAT PIPES AND HEAT PRODUCTION USING THE HEAT RECOVERED FROM THE SERVER(S)

(30) Priorité: 30.06.2017 FR 1756185
(43) Date de publication de la demande: 02.01.2019
(73) Titulaire: Commissariat à l'Energie Atomique et aux Energies Alternatives, 75015 Paris (FR)
(72) Inventeur: GRUSS, Jean-Antoine, 38170 SEYSSINET (FR); LEVEQUE, Marie, 38000 GRENOBLE (FR)
(74) Mandataire: Nony

(56) Documents cités:
- EP-A2- 0 269 065
- NL-C- 2 005 718
- US-A1- 2007 267 741
- US-A1- 2016 014 932
- US-A1- 2016 324 033

## Description

### Domaine technique

La présente invention concerne le refroidissement de serveurs informatiques et de production de chaleur à partir de celle récupérée du (des) serveur(s).

Elle a trait plus particulièrement à un système de refroidissement dans lequel le(s) serveur(s) est(sont) immergé(s) dans un bain d'huile qui sert à récupérer la chaleur pour faire du chauffage d'eau chaude sanitaire et/ou du chauffage de bâtiment.

L'invention vise à optimiser l'efficacité d'un tel système.

### Art antérieur

Il a déjà été envisagé de refroidir des serveurs informatiques au moyen d'une circulation d'huile. L'huile est en effet un fluide qui est un meilleur conducteur de la chaleur que l'air. Elle permet ainsi d'évacuer plus facilement la chaleur et surtout permet de faire de la haute densité avec un ratio au m² qui serait impossible dans un environnement traditionnel refroidi à l'air.

La société américaine Green Revolution Cooling (GRC) développe ainsi des serveurs utilisant pour le refroidissement une immersion en bain d'huile fonctionnant en monophasique. L'huile utilisée appelée « Greendef» est une huile minérale diélectrique.

Les performances thermiques de ce système, dénommé «CarnotJet» sont limitées du fait de la faible vitesse de circulation de l'huile qui est atteinte entre les cartes de serveur. De plus, les processeurs sont montés sur une plaque froide, qui est dimensionnée pour un refroidissement à air et non optimisée pour un refroidissement à huile.

La société GRC propose dans la demande de brevet US 2016/0014932, la mise en place des circulateurs permettant d'augmenter la vitesse de fluide dans le rack dans lequel sont reçues les cartes de serveur. Il est également mentionné la présence des buses permettant d'augmenter la vitesse d'entrée du fluide dans le rack.

La société LCS commercialise des systèmes dans lesquels chaque carte de serveur est enfermée dans un boitier étanche dans lequel circule une huile diélectrique commercialisée sous la dénomination Opticool « 87252 ». Le boitier logeant la carte peut être connecté au circuit hydraulique grâce à des connecteurs hydrauliques auto-obturants. Le circuit hydraulique est réalisé de telle manière à obtenir un échange de chaleur à l'intérieur du boitier. Cette solution est assez coûteuse car il faut réaliser un grand nombre de boitiers étanches et de passages électriques étanches, proportionnel au nombre de cartes de serveur. En outre, avec des cartes de serveur usuelles, le circuit de circulation interne du fluide n'est pas optimum du fait de la disposition des composants de puissance qui n'est pas prévue pour ce type de refroidissement.

Le brevet US 9,223,360 décrit une méthode d'intensification de l'échange thermique consistant à amener sur la carte de serveur, immergée dans une huile diélectrique, un tuyau directement vers les composants de puissance. Ce tuyau permet d'amener l'huile dans un refroidisseur fermé par un capot, qui ressort de ce dernier et est mélangée au bain d'huile d'immersion de la carte de serveur.

Le brevet US 8,305,759 décrit également un système de refroidissement de carte de serveur par huile qui est logée dans un carter. L'huile est pompée en partie basse du carter, amenée par tuyaux sur des refroidisseurs fermés par des capots sur les composants de puissance, puis s'écoule par gravité. L'huile est pompée de plus dans un radiateur à air externe permettant de refroidir l'huile.

Dans toutes les solutions précitées, la sortie de fluide draine l'ensemble de la puissance thermique dégagée par tous les composants informatiques et la température d'huile en sortie de système est la température à laquelle la carte de serveur est exposée.

Si on veut obtenir une température de sortie d'huile élevée, il faut donc nécessairement que la carte et le carter ou boitier étanche soit portés à cette température.

Ceci pose des problèmes de tenue des composants de la carte à cette haute température, ainsi que d'isolation thermique du carter ou boitier.

Le brevet US 7,724,524 décrit un système de refroidissement de cartes de serveur comprenant des composants de puissance refroidis par des plaques froides alimentées par circulation d'un premier fluide, alors que la carte est immergée dans un deuxième fluide. Il existe un échange de chaleur entre le premier et le second fluide, le premier fluide transportant l'ensemble de la puissance thermique générée vers la source froide. L'échange de chaleur entre le premier et le second fluide peut être réalisé de plusieurs manières :
- échange par convection naturelle,
- surfaces d'échange définies par l'extérieur des plaques froides et les tuyaux de raccordement du premier fluide,
- brassage du deuxième fluide au moyen d'une pompe,
- évaporation du deuxième fluide (diphasique).

Dans ce brevet US 7,724,524, il est prévu également d'installer les cartes de serveur en rack, avec des connecteurs hydrauliques en fonds de panier pour le circuit de refroidissement.

Il existe par ailleurs des systèmes de refroidissement de serveurs informatiques, à circulation d'huile diélectrique qui sont conçus pour récupérer la chaleur générée par les composants informatiques, afin de faire du chauffage eau chaude sanitaire et/ou de chauffage bâtiment. Pour des raisons sanitaires, la température d'eau qui doit être délivrée au circuit d'eau chaude sanitaire doit être de l'ordre de 65°C.

Ces systèmes imposent une température de boitier de composants électroniques maximale, typiquement de l'ordre de 75°C, notamment pour garantir la sécurité des personnes.

Dans ces systèmes, les cartes électroniques sont immergées dans de l'huile diélectrique sont relativement mal refroidies du fait des mauvaises propriétés de l'huile.

Une circulation de l'huile générée par une pompe permet d'obtenir un échange meilleur et d'envoyer l'huile dans un échangeur intermédiaire huile/eau.

De ce fait, l'écart de température entre les composants électroniques les plus chauds, typiquement les microprocesseurs est élevé, ce qui entraine à température de boitier imposée, une température de l'huile de refroidissement nécessairement faible.

La conséquence est que la chaleur récupérée par ces systèmes de refroidissement n'est pas suffisante pour atteindre les 65°C requis pour l'eau chaude sanitaire, ce qui nécessite donc un apport d'énergie complémentaire par d'autres moyens (gaz, électrique, solaire...). Pour les autres applications qui ne nécessitent pas une température de 65°C, il peut être intéressant d'avoir cette température pour des questions énergétiques.

Il existe également d'autres systèmes de refroidissement de serveurs à circulation d'huile dans lesquels l'échange thermique a été amélioré au niveau des composants, afin d'obtenir à la sortie, une huile à température élevée, typiquement de l'ordre de 70°C, de manière à obtenir une eau chaude sanitaire à 65°C, grâce à un échangeur intermédiaire.

Néanmoins, dans ces autres systèmes, toute la carte est portée à haute température, ce qui est nocif pour certains composants de cette carte et pose des problèmes d'isolation thermique et de sécurité des personnes du fait de brûlures possibles. Autrement dit, ces systèmes ne sont pas viables en pratique.

La société STIMERGY commercialise déjà des centres de données (« data centers » en anglais), refroidis par huile, qui sont installés dans des immeubles. Dans les systèmes commercialisés, l'huile est pompée à travers les cartes de serveurs placées à la verticale, les processeurs étant équipés de leur refroidisseur à ailettes d'origine. L'énergie thermique est récupérée grâce un échangeur huile/air, pour faire de l'eau chaude sanitaire.

Les refroidisseurs à ailettes prévus à l'origine pour un refroidissement à air, ne sont pas adaptés à un fonctionnement dans de l'huile. En effet, d'une part, le design des ailettes (hauteur, épaisseur, pas) n'est pas optimal pour un fonctionnement dans de l'huile à la place de l'air. D'autre part, la vitesse de circulation de l'huile est très faible, à moins d'installer une pompe surdimensionnée. Pour ces raisons, et compte tenu des propriétés thermo-physiques de l'huile utilisée, l'échange thermique, réalisé par le biais d'un refroidisseur à ailettes, entre le composant électronique le plus chaud qui est le processeur (ou unité centrale de traitement (UCT) ou en anglais « central processing unit » (CPU)) et l'huile n'est pas très bon.

Par voie de conséquence, il faut une différence de température élevée entre le processeur (CPU) et l'huile pour assurer le refroidissement de ce dernier.

On connait par ailleurs, en tant que dispositifs de transfert de chaleur, les caloducs, qui sont constitués d'une enceinte fermée dans laquelle circule un fluide à l'état de saturation entre une source chaude où il s'évapore, et une source froide où il se condense, et cela à température quasi constante : voir par exemple publication [1].

Un type particulier de caloducs est appelé thermosiphon diphasique. On précise que dans le cadre de l'invention, on entend par « thermosiphon diphasique », le sens usuel connu de l'homme du métier tel que défini dans la publication [2]. Ainsi, un thermosiphon diphasique est un caloduc qui permet de transférer de la chaleur par évaporation/condensation d'un fluide à l'intérieur d'une enveloppe sans aucune structure capillaire, c'est-à-dire avec un retour des condensats par gravité à l'intérieur de l'enveloppe.

Un autre type particulier de caloducs particulièrement simple et performant est appelé caloduc pulsé ou oscillant (en anglais « *Pulsating Heat Pipe* » d'acronyme PHP, ou encore « *Oscillating Heat Pipe* » (OHP)) : voir aussi publication [2]. Un caloduc pulsé est un dispositif de transfert thermique diphasique passif constitué d'un tube capillaire recourbé sur lui-même selon plusieurs courbures en aller-retour reliées par des coudes formant ainsi un réseau de capillaires. Chacune des extrémités au niveau des coudes est respectivement en contact avec une source froide et une source chaude. Un fluide y est introduit à l'état de saturation avec un taux de remplissage compris entre 40% et 80% du volume du tube. En régime de fonctionnement, des oscillations de bouchons de liquide et de bulles de vapeur apparaissent dans le système à partir d'un flux thermique suffisant imposé à l'évaporateur. Deux types de transferts sont donc mis en œuvre :
- le transfert de chaleur latente par évaporation du film liquide, qui va faire naître des fluctuations de pression et ainsi pousser en quelque sorte les bouchons entre l'évaporateur et le condenseur,
- le transfert de chaleur sensible transportée par les bouchons de liquide qui vont échanger entre l'évaporateur et le condenseur.

Il existe un besoin d'améliorer les systèmes de refroidissement de serveurs informatiques, à circulation d'huile, notamment afin de récupérer la chaleur dégagée par les serveurs en vue de faire du chauffage eau chaude sanitaire et/ou de chauffage bâtiment, tout en garantissant à la fois un refroidissement efficace des composants électroniques y compris ceux les plus chauds, et ce même en cas de température maximale imposée de leur boitier, typiquement de l'ordre de 75°C.

### Exposé de l'invention

Pour ce faire, l'invention concerne, sous l'un de ses aspects, et selon une première alternative, un système de refroidissement d'un ou plusieurs serveurs informatiques et de production de chaleur à partir de la chaleur récupérée du (des) serveur(s), comprenant :
- un récipient étanche, rempli d'une huile diélectrique ;
- au moins une carte électronique supportant une pluralité de composants électroniques, les cartes électroniques étant agencées à la verticale à l'intérieur du récipient en étant immergées dans l'huile diélectrique et séparées les unes des autres entre une portion inférieure et une portion supérieure du récipient;
- au moins une plaque, dite plaque froide, chaque plaque froide étant couplée thermiquement à un ou plusieurs des composants électroniques d'une même carte qui sont les plus générateurs de chaleur ;
- un échangeur eau/huile, agencé à l'extérieur du récipient;
- une pompe à huile,
- un circuit de fluide fermé, le fluide contenant l'huile diélectrique mise en circulation par la pompe à huile, le circuit fermé comprenant en série fluidique:
   - un des circuits, dit circuit d'huile, de l'échangeur,
   - au moins un conduit reliant le circuit d'huile de l'échangeur à la portion inférieure ou la portion supérieure de l'intérieur du récipient,
   - l'intérieur du récipient,
   - au moins un conduit reliant la portion supérieure ou la portion inférieure de l'intérieur du récipient à l'entrée de la plaque froide,
   - au moins un conduit reliant la sortie de la plaque froide au circuit d'huile de l'échangeur,
le circuit de fluide fermé étant ainsi configuré de sorte à avoir un refroidissement de la plaque froide en sortie et en série avec le refroidissement du ou des composants électroniques.

Selon un mode de réalisation avantageux, le système comprend:
- une pluralité de cartes électroniques agencées en étant séparées les unes des autres;
- une pluralité de plaques froides;
le circuit de fluide fermé sur lui-même comprenant en série fluidique:
- le circuit d'huile de l'échangeur,
- le conduit reliant le circuit d'huile de l'échangeur à la portion inférieure ou la portion supérieure de l'intérieur du récipient,
- les espaces de séparation entre les cartes électroniques adjacentes;
- une pluralité de conduits reliant chacun la portion supérieure ou la portion inférieure de l'intérieur du récipient à l'entrée à l'entrée d'une des plaques froides,
- une pluralité de conduits reliant chacun la sortie d'une des plaques froides au circuit d'huile de l'échangeur,
le circuit de fluide fermé étant ainsi configuré de sorte à avoir un refroidissement des plaques froides en sortie et en série avec le refroidissement du ou des composants électroniques.

Lorsque la circulation de l'huile diélectrique est faite de bas vers le haut dans le récipient (réservoir), les gammes de températures préférées de l'huile avec le refroidissement par plaques froides peuvent être les suivantes :
- en entrée, au niveau inférieur du réservoir, de 58,5 à 68,5°C typiquement de l'ordre de 63, 5°C,
- en sortie, au niveau supérieur du réservoir, de 60 à 70°C typiquement de l'ordre de 65°C.

En considérant pour des cartes serveur, environ 30% de la puissance thermique dans les cartes et 70% dans les processeurs, la température de l'huile diélectrique en sortie des plaques froides est de préférence comprise entre 63,5 à 73,5°C typiquement de l'ordre de 68°C.

Dans ces conditions, la température d'huile avant d'entrer dans le condenseur peut être de l'ordre de 61, 8°C.

L'huile diélectrique est avantageusement choisie parmi une huile minérale, silicone, à base d'esters naturels, à base d'esters synthétiques, à base de fluorocétone.

Selon un mode réalisation avantageux, le système comprend un boitier à l'intérieur duquel sont logés le récipient, la pompe, l'échangeur eau/huile et les conduits.

L'invention concerne également selon une deuxième alternative, un système de refroidissement d'un ou plusieurs serveurs informatiques et de production de chaleur à partir de la chaleur récupérée du (des) serveur(s), comprenant :
- un récipient étanche, rempli d'une huile diélectrique ;
- au moins une carte électronique supportant une pluralité de composants électroniques, la carte électronique étant agencée à la verticale à l'intérieur du récipient entre une portion inférieure et une portion supérieure du récipient et en étant immergée dans l'huile diélectrique ;
- au moins une platine comprenant un caloduc, dont la zone de chauffage, dite évaporateur, est couplée thermiquement à un à un ou plusieurs des composants électroniques d'une même carte qui sont les plus générateurs de chaleur, tandis que la zone de refroidissement, dite condenseur, est agencée dans la portion supérieure ou la portion inférieure du récipient, et de préférence, un élément à surface d'échange thermique développée fixé sur le condenseur;
- un échangeur eau/huile, agencé à l'extérieur du récipient;
- une pompe à huile,
- un circuit de fluide fermé, contenant l'huile diélectrique mise en circulation par la pompe à huile, le circuit fermé comprenant en série fluidique:
   - un des circuits, dit circuit d'huile, de l'échangeur,
   - un conduit reliant le circuit d'huile de l'échangeur à la portion inférieure ou la portion supérieure respectivement de l'intérieur du premier récipient,
   - l'intérieur du récipient,
   - au moins un conduit reliant la portion supérieure ou la portion inférieure de l'intérieur du récipient au circuit d'huile de l'échangeur,
le circuit de fluide fermé étant ainsi configuré de sorte à avoir un refroidissement en série des composants d'une carte électronique, les plus générateurs de chaleur, puis des autres composants de la même carte électronique.

Selon un mode de réalisation avantageux, le système comprend une pluralité de cartes électroniques et une pluralité de caloducs, le circuit de fluide fermé étant ainsi configuré de sorte à avoir un refroidissement en série des composants de chacune des cartes électroniques, les plus générateurs de chaleur, puis des autres composants de la même carte électronique.

Avantageusement, la pompe à huile peut être agencée entre l'entrée ou la sortie de l'échangeur eau/huile et la portion inférieure ou supérieure du récipient.

Les platines peuvent être avantageusement en aluminium ou en cuivre.

De préférence, les caloducs sont des caloducs appelés caloducs pulsés ou oscillants.

Selon une variante de réalisation avantageuse, les caloducs comprenant une enveloppe constituée d'une plaque métallique gravée d'une pluralité de canaux et assemblée à une plaque métallique de fermeture, les canaux étant remplis du fluide caloduc.

Avantageusement, les caloducs comprennent une plaque métallique sur laquelle sont fixés des tubes remplis du fluide caloduc.

Les enveloppes ou tubes des caloducs peuvent être en cuivre remplis d'eau.

Avantageusement, le condenseur des caloducs est agencé au-dessus de l'évaporateur des caloducs.

Les éléments à surface développée peuvent être avantageusement des dissipateurs thermiques à ailettes.

Lorsque la circulation de l'huile diélectrique est faite de bas vers le haut dans le récipient (réservoir), les gammes de températures préférées de l'huile avec le refroidissement par caloducs peuvent être les suivantes :
- en entrée, au niveau inférieur du réservoir, de 55,3 à 65,3°C typiquement de l'ordre de 60,3 °C,
- en sortie, au niveau supérieur du réservoir, de 60,3 à 70,3°C typiquement de l'ordre de 65,3°C.

Dans ces conditions, la température d'huile avant d'entrer dans le condenseur peut être de l'ordre de 61, 8°C.

Par « couplée thermiquement », on entend ici et dans le cadre de l'invention, un mode de liaison mécanique qui permet une conduction thermique avec le ou les composants électroniques.

Par « série fluidique », on entend ici et dans le cadre de l'invention, que les composants sont parcourus à la suite les uns des autres par le même flux de fluide diélectrique.

Ainsi, l'invention consiste essentiellement à définir un unique circuit de refroidissement qui permet de faire circuler une huile diélectrique sur une carte électronique ou entre les cartes électroniques du ou des serveurs immergées dans un bain au sein du récipient, puis en série fluidique, au travers des moyens de refroidissement spécifiques (plaques froides, caloducs) aux composants les plus chauds, à soutirer l'huile au niveau de la partie supérieure du récipient et la faire traverser la partie de l'échangeur de sorte à ce que l'huile diélectrique cède sa chaleur au circuit d'eau de l'échangeur.

Grâce à l'invention, avec un refroidissement en série, on augmente la résistance thermique entre les composants les plus chargés thermiquement tels que les composants de puissance du type microprocesseurs et l'huile de refroidissement.

Par voie de conséquence, on peut obtenir en sortie du système, une température d'huile élevée, tout en gardant une température d'huile à l'intérieur du récipient qui est modérée.

Selon l'alternative au moyen des plaques froides, le circuit de refroidissement par plaques est branché en sortie et en série avec le circuit de refroidissement des composants électroniques.

Selon l'alternative au moyen des caloducs, la partie refroidissement du caloduc (condenseur) se trouve en partie haute du réservoir avec une huile qui circule de bas en haut, ce qui fait que l'huile refroidit essentiellement en série les composants de la carte, puis les composants de puissance au niveau du condenseur.

En lieu et place de plaques froides à l'intérieur desquelles circule l'huile diélectrique, on peut installer sur les composants électroniques les plus chauds, tels que les processeurs CPU, un dissipateur intégrant un ou plusieurs caloducs qui permet de transférer la chaleur à l'huile dans la partie supérieure du récipient, dans laquelle cette huile est prélevée pour être envoyée dans un échangeur huile/eau.

Ceci permet d'une part de minimiser l'écart de température entre les composants et l'huile en développant la surface d'échange avec l'huile, et d'autre part de n'avoir une huile très chaude qu'en haut du récipient, et ainsi de ne pas exposer l'ensemble des composants de la carte à une température élevée.

En augmentant fortement la résistance thermique entre les composants de puissance et l'huile diélectrique, l'invention permet, comparativement aux systèmes de refroidissement selon l'état de l'art, de pouvoir monter la température de l'huile à température de boitier de ces composants fixée, de l'ordre de 75°C, et par conséquent, celle de l'eau en sortie d'échangeur à environ 65°C.

Grâce à l'invention, on peut donc valoriser la chaleur dégagée par les serveurs informatiques pour faire de l'eau chaude sanitaire sans avoir à relever le niveau de température, tout en maintenant les composants supportés par les carte de serveurs dans l'huile à une température moyenne d'immersion dans le bain qui est modérée.

L'invention concerne ainsi l'utilisation du système qui vient d'être décrit pour réaliser le chauffage d'eau sanitaire d'un bâtiment ou d'une piscine, la climatisation par absorption, ou encore la désalinisation par voie thermique, par le biais du circuit d'eau de l'échangeur.

### Description détaillée

D'autres avantages et caractéristiques de l'invention ressortiront mieux à la lecture de la description détaillée d'exemples de mise en œuvre de l'invention faite à titre illustratif et non limitatif en référence aux figures suivantes parmi lesquelles :
- la figure 1 est une représentation schématique d'un exemple d'un système de refroidissement de serveurs informatiques selon une première alternative de l'invention;
- la figure 2 est une représentation schématique d'un exemple d'un système de refroidissement de serveurs informatiques selon une deuxième alternative de l'invention ;
- la figure 3 est une vue en perspective d'une carte électronique qui intègre un caloduc selon la deuxième alternative de l'invention ;
- la figure 4 est une vue en perspective du caloduc de la figure 4 ;
- la figure 5 est une vue de face détaillant une réalisation avantageuse du caloduc de la figure 4 en caloduc pulsé.

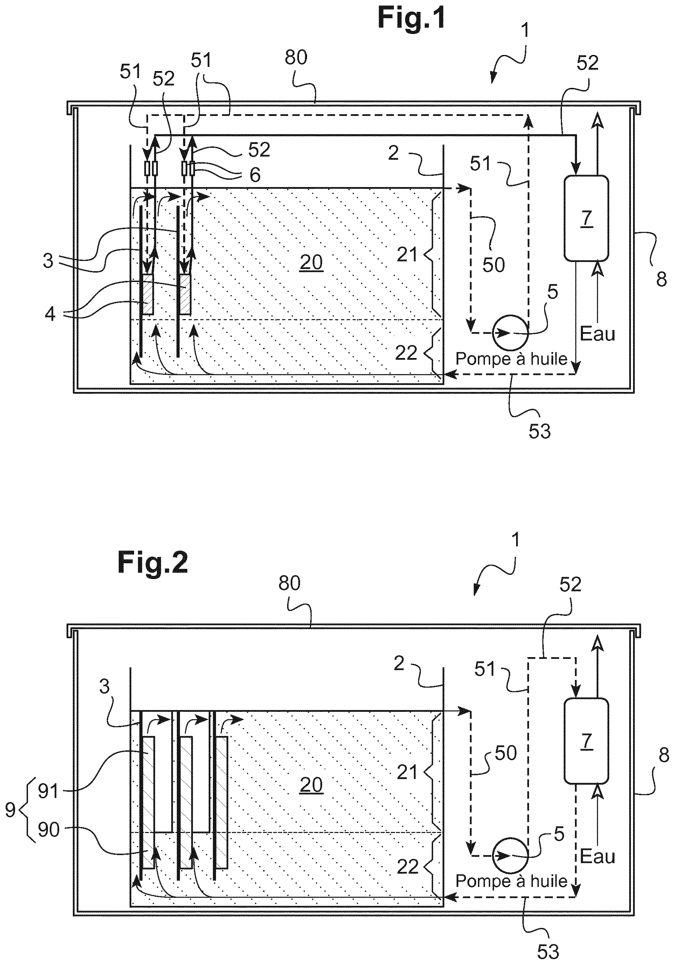

Par souci de clarté, les mêmes références désignant les mêmes éléments système selon l'invention sont utilisées pour les deux alternatives des figures 1 à 5.

Dans l'ensemble de la présente demande, les termes « inférieur », « supérieur », « bas », « haut », « dessous » et « dessus » sont à comprendre par référence à un récipient dans lequel le bain d'huile est réalisé, qui est positionné à la verticale avec son ouverture sur le dessus.

De même, les termes « entrée», « sortie », «amont », « aval», sont à comprendre par référence à la circulation du fluide diélectrique au sein du circuit de refroidissement selon l'invention

Le système de refroidissement 1 selon la figure 1 comprend tout d'abord un récipient 2 étanche qui est ouvert sur le dessus et à l'intérieur duquel est logé un rack, non représenté, adapté pour supporter des cartes électroniques 3 de serveurs, agencées à la verticale.

Le récipient 2 est rempli d'un bain 20 de fluide diélectrique, de préférence d'huile diélectrique. L'huile est par exemple l'huile commercialisée sous la dénomination « Opticool 87252 » par la Société Opticool technologies. D'autres huiles diélectriques peuvent bien évidemment convenir. On peut ainsi envisager une huile minérale, une huile à base de silicone, une huile à base d'esters naturels, par exemple à base de soja, une huile à base d'esters synthétiques, à base de fluorocétone...

L'ensemble des cartes électroniques 3 est complétement immergé dans le bain d'huile 20 entre une portion supérieure 21 et une portion inférieure 22 du récipient 2.

Les cartes 3 sont espacées les unes des autres afin de pouvoir faire circuler un flux d'huile diélectrique.

Chaque carte électronique 3 supporte une ou plusieurs plaques froides 4. Chaque plaque froide 4 est couplée thermiquement à un ou plusieurs des composants électroniques d'une même carte qui sont les plus chargés thermiquement ou autrement dit les plus générateurs de chaleur.

Typiquement, sur les cartes de serveur, la majorité de la puissance thermique à dissiper est concentrée au niveau des processeurs (CPU) dont la température du boitier doit être maintenue en dessous d'environ 75°C, afin de ne pas endommager le CPU et assurer une durée de vie suffisante (typiquement plusieurs années).

Ainsi, chaque plaque froide 4 peut avoir des dimensions équivalentes ou légèrement supérieures à celles du boitier d'un CPU. Comme expliqué par la suite, l'huile diélectrique qui va circuler à l'intérieur d'une plaque froide 4 va ainsi refroidir par conduction le boitier du CPU.

Chaque plaque froide peut être avantageusement réalisée en alliage d'aluminium, cuivre, ou combinaison des deux.

Une pompe à huile 5 est reliée d'une part à la portion supérieure 21 du récipient 2 par un conduit 50 et d'autre part à l'entrée de chacune de plaques froides 4 par l'intermédiaire de connecteurs hydrauliques 6 et d'une pluralité de conduits 51.

Tel qu'illustrée, la pompe à huile 5 est de préférence agencée dans une position correspondant à la portion inférieure 22 du récipient 2, afin d'assurer une hauteur de charge suffisante pour son fonctionnement.

La sortie de chaque plaque froide 4 est quant à elle reliée à l'entrée d'un premier circuit de fluide d'un échangeur de chaleur 7 par une pluralité de conduits 52. L'échangeur de chaleur est un échangeur huile/eau par exemple.

La sortie du premier circuit de fluide de l'échangeur 7 est reliée à la portion inférieure 21 du récipient 2 par un conduit 53.

Selon un mode de réalisation avantageux, il est prévu un boitier externe 8 étanche, qui peut être fermé par un couvercle 80, et dans lequel sont logés le récipient 2 ainsi que la pompe à huile 5, l'échangeur huile/eau 7 et le cas échéant d'autres composants, tels que des composants d'alimentation et de protection électrique de la pompe 5 et/ou de l'échangeur 7 ...

Le fonctionnement du système de refroidissement montré en figure 1 va maintenant être expliqué.

La pompe 5 en état de marche fait circuler l'huile dans le bain 20 à l'intérieur du récipient 2 de bas en haut à travers les espaces séparant les cartes électroniques 3, puis dans les plaques froides 4, et enfin dans l'échangeur huile/eau 7.

L'huile diélectrique circule de bas en haut entre les cartes électroniques 3, afin de bénéficier de la convection naturelle qui s'ajoute à la convection forcée procurée par la pompe 5.

L'huile réchauffée est ensuite soutirée au niveau de la portion supérieure 21 du récipient 2 par la pompe 5, passe au travers de celle-ci puis dans les plaques froides 4 avant d'être envoyée dans l'échangeur huile/eau 7 dans lequel elle cède sa chaleur à l'eau circulant dans un deuxième circuit de fluide de l'échangeur.

L'huile sort de l'échangeur à température plus froide et retourne alors vers le bas du récipient 2.

Le circuit d'eau chaude est par exemple de l'eau sanitaire dont la température est aux environs de 65°C à la sortie de l'échangeur. La chaleur dégagée par le refroidissement qui vient d'être décrit peut également être valorisée pour d'autres applications, comme le chauffage de bâtiment ou de piscine, la climatisation par absorption, ou encore la désalinisation par voie thermique...

La figure 2 illustre une autre alternative de l'invention selon laquelle les plaques froides 4 sont remplacées par des dissipateurs à caloducs 9.

Chaque caloduc 9 est fixé à une platine. Cette platine est réalisée de préférence avec une très faible épaisseur afin de ne pas obstruer l'espace entre deux cartes adjacentes 3 dans lequel circule l'huile et également de maximiser la surface d'échange développée.

Chaque caloduc 9 comprend une partie dite partie chaude 90 sur laquelle est fixé un boitier de composant de puissance 10, tel qu'un CPU et une partie froide 90 immergée dans le bain d'huile 20.

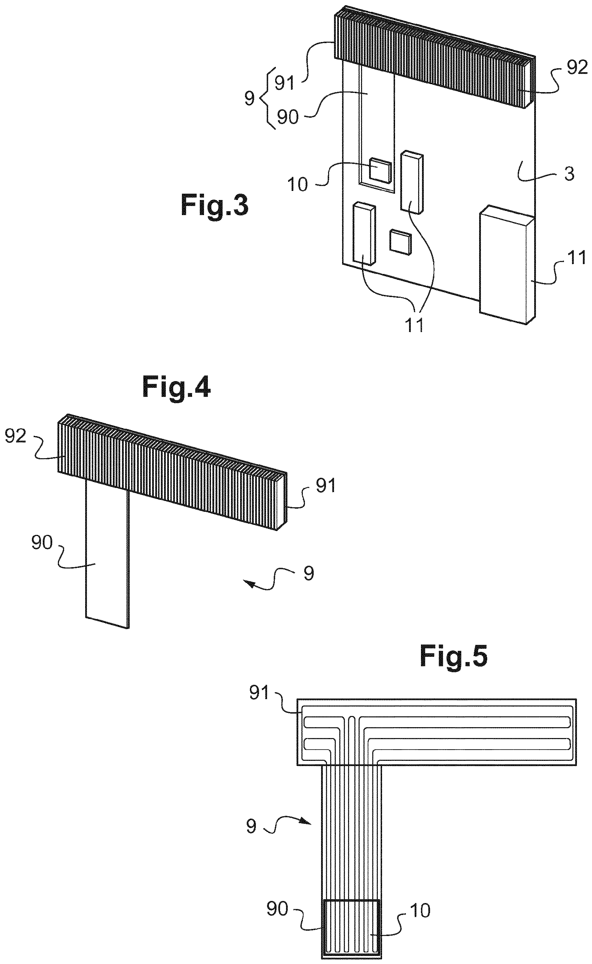

L'intégration préférée dans une carte électronique 3 d'une platine support de caloduc 9 est montrée en figure 3 :
De préférence, comme illustré en figure 2, la partie froide 91 est agencée au-dessus de la partie chaude afin de pouvoir avoir un retour des condensats par gravité au sein du caloduc 9.

Selon une variante préférée, comme illustré aux figures 3 à 5, un élément à surface développée 92 est fixé sur la partie froide 91 du caloduc 9.

Comme illustré en figures 3 et 4, l'élément à surface développée 92 est avantageusement à ailettes qui permettent d'augmenter la surface d'échange, tout en assurant une intensification des échanges.

Les ailettes peuvent être des ailettes continues, segmentées, des ailettes sous forme de pointes profilées ou non. La surface développée de l'élément 92 peut être toute autre surface permettant d'optimiser l'échange convectif avec l'huile.

Comme montré par transparence en figure 5, le caloduc 9 est de préférence un caloduc pulsé constitué d'un capillaire de petit diamètre formant un serpentin. De préférence, le diamètre de capillaire est compris entre 1 et 3 mm.

Le caloduc pulsé sera réalisé préférentiellement en cuivre et rempli en eau.

La platine chaude caloduc pulsé est réalisée préférentiellement en aluminium ou en cuivre.

D'autres matériaux et fluides compatibles sont envisageables: aluminium/acétone ou méthanol notamment mais également tous les matériaux et fluides caloducs connus de l'homme de l'art.

Le fonctionnement du système avec les caloducs 9 est le suivant : la pompe 5 en état de marche fait circuler l'huile dans le bain 20 à l'intérieur du récipient 2, de bas en haut à travers les espaces séparant les cartes électroniques 3 et sur les caloducs 9, puis dans l'échangeur huile/eau 7.

L'huile diélectrique circule ainsi de bas en haut entre les cartes électroniques 3, et sur les parties chaudes 90 des caloducs 9 sur lesquelles sont fixées les composants les plus chargés thermiquement 10.

La chaleur de ces composants 10 est ainsi évacuée par l'intermédiaire des caloducs 9 vers leur partie froide 91 où elle est évacuée par convection, de préférence au moyen des éléments à surface développée 92, dans la portion supérieure 21 du récipient 2 au sein du bain d'huile 20.

L'huile réchauffée est ensuite soutirée au niveau de la portion supérieure 21 du récipient 2 par la pompe 5, passe au travers de celle-ci puis est envoyée directement dans l'échangeur huile/eau 7 dans lequel elle cède sa chaleur à un circuit d'eau.

Un exemple de températures d'huile diélectrique obtenues à différents endroits d'une part du circuit fermé d'huile diélectrique et d'autre part du circuit d'eau est indiqué dans le tableau ci-dessous.

**TABLEAU**

| **Température en °C** | **Figure 1** **avec refroidissement par plaques froides 4** | **Figure 2** **avec refroidissement par caloducs 9** |
|---|---|---|
| Température en entrée huile, en bas de récipient 2 | 63,5 | 60,3 |
| Température en sortie huile, en haut de récipient 2 | 68,5 | 65,3 |
| Température moyenne huile au sein du récipient 2 | 65,0 | 61,8 |
| Température en entrée d'eau | 55,5 | 52,3 |
| Température en sortie d'eau | 60,5 | 57,3 |

D'autres avantages et améliorations peuvent être prévus sans pour autant sortir du cadre de l'invention.

L'invention n'est pas limitée aux exemples qui viennent d'être décrits ; on peut notamment combiner entre elles des caractéristiques des exemples illustrés au sein de variantes non illustrées.

On peut par exemple combiner les deux alternatives selon les figures 1 et 2.

L'expression « comportant un » ou « comprenant un » doit être comprise comme étant synonyme de « comportant au moins un », sauf si le contraire est spécifié.

### Références citées

[1] : Reay D, Kew P: 2006, « Heat pipes - Theory, design and applications », Butterworth-Heinemann ;
[2] : Bonjour J, Lefevre F, Sartre V, Bertin Y, Romestant C, Ayel V et Platel V, 2011, « Systèmes Diphasiques de Contrôle Thermique - Microcaloducs Et Caloducs Oscillants », Techniques De L'Ingénieur, Vol. BE9547.

## Revendications

1. Système de refroidissement (1) d'un ou plusieurs serveurs informatiques et de production de chaleur à partir de la chaleur récupérée du (des) serveur(s), comprenant :
- un récipient (2) étanche, rempli d'une huile diélectrique ;
- au moins une carte électronique (3) supportant une pluralité de composants électroniques, la carte électronique étant agencée à la verticale à l'intérieur du récipient entre une portion inférieure et une portion supérieure du récipient et en étant immergée dans l'huile diélectrique ;
- au moins une platine comprenant un caloduc, dont la zone de chauffage, dite évaporateur, est couplée thermiquement à un à un ou plusieurs des composants électroniques d'une même carte qui sont les plus générateurs de chaleur, tandis que la zone de refroidissement, dite condenseur, est agencée dans la portion supérieure ou la portion inférieure du récipient, et de préférence, un élément à surface d'échange thermique développée fixé sur le condenseur;
- un échangeur (7) eau/huile, agencé à l'extérieur du récipient;
- une pompe à huile (5),
- un circuit de fluide fermé, contenant l'huile diélectrique mise en circulation par la pompe à huile, le circuit fermé comprenant en série fluidique:
• un des circuits, dit circuit d'huile, de l'échangeur,
• un conduit (53) reliant le circuit d'huile de l'échangeur à la portion inférieure ou la portion supérieure respectivement de l'intérieur du premier récipient,
• l'intérieur du récipient,
• au moins un conduit (50) reliant la portion supérieure ou la portion inférieure de l'intérieur du récipient au circuit d'huile de l'échangeur,
le circuit de fluide fermé étant ainsi configuré de sorte à avoir un refroidissement en série des composants d'une carte électronique, les plus générateurs de chaleur, puis des autres composants de la même carte électronique.

2. Système selon la revendication 1, comprenant une pluralité de cartes électroniques et une pluralité de caloducs, le circuit de fluide fermé étant ainsi configuré de sorte à avoir un refroidissement en série des composants de chacune des cartes électroniques, les plus générateurs de chaleur, puis des autres composants de la même carte électronique.

3. Système selon la revendication 1 ou 2, les platines étant en aluminium ou en cuivre.

4. Système selon l'une des revendications 1 à 3, les caloducs étant des caloducs appelés caloducs pulsés ou oscillants.

5. Système selon l'une des revendications précédentes, les caloducs comprenant une enveloppe constituée d'une plaque métallique gravée d'une pluralité de canaux et assemblée à une plaque métallique de fermeture, les canaux étant remplis du fluide caloduc.

6. Système selon l'une des revendications précédentes, les caloducs comprenant une plaque métallique sur laquelle sont fixés des tubes remplis du fluide caloduc.

7. Système selon l'une des revendications 5 ou 6, les enveloppes ou tubes des caloducs étant en cuivre remplis d'eau.

8. Système selon l'une des revendications précédentes, le condenseur des caloducs étant agencé au-dessus de l'évaporateur des caloducs.

9. Système selon l'une des revendications précédentes, les éléments à surface développée étant des dissipateurs thermiques à ailettes.

10. Système selon l'une des revendications précédentes, l'huile diélectrique étant choisie parmi une huile minérale, silicone, à base d'esters naturels, à base d'esters synthétiques, à base de fluorocétone.

11. Système selon l'une des revendications précédentes, comprenant un boitier à l'intérieur duquel sont logés le récipient, la pompe, l'échangeur eau/huile et les conduits.

12. Utilisation du système selon l'une des revendications précédentes pour réaliser le chauffage d'eau sanitaire d'un bâtiment ou d'une piscine, la climatisation par absorption, ou encore la désalinisation par voie thermique, par le biais du circuit d'eau de l'échangeur.

## Patentansprüche

1. System (1) zur Kühlung eines oder mehrerer IT-Server und zur Wärmeerzeugung ausgehend von der von dem(den) Server (n) wiedergewonnenen Wärme, das enthält:
- einen dichten Behälter (2), der mit einem dielektrischen Öl gefüllt ist;
- mindestens eine Elektronikkarte (3), die eine Vielzahl elektronischer Bauteile trägt, wobei die Elektronikkarte senkrecht im Inneren des Behälters zwischen einem unteren Abschnitt und einem oberen Abschnitt des Behälters angeordnet und in das dielektrische Öl eingetaucht ist;
- mindestens eine Platine, die ein Wärmerohr, dessen Heizzone, Verdampfer genannt, thermisch mit einem oder mehreren der elektronischen Bauteile einer gleichen Karte gekoppelt ist, die am meisten Wärme erzeugen, während die Kühlzone, Verflüssiger genannt, im oberen Abschnitt oder unteren Abschnitt des Behälters angeordnet ist, und vorzugsweise ein Element mit abgewickelter Wärmeaustauschfläche enthält, das am Verflüssiger befestigt ist;
- einen Wasser-Öl-Tauscher (7), der außerhalb des Behälters angeordnet ist;
- eine Ölpumpe (5),
- einen geschlossenen Fluidkreislauf, der das dielektrische Öl enthält, das von der Ölpumpe in Umlauf gebracht wird, wobei der geschlossene Kreislauf in fluidischer Reihe geschaltet enthält:
• einen der Kreisläufe, Ölkreislauf genannt, des Tauschers,
• einen Kanal (53), der den Ölkreislauf des Tauschers mit dem unteren Abschnitt bzw. dem oberen Abschnitt des Inneren des ersten Behälters verbindet,
• das Innere des Behälters,
• mindestens einen Kanal (50), der den oberen Abschnitt oder den unteren Abschnitt des Inneren des Behälters mit dem Ölkreislauf des Tauschers verbindet,
wobei der geschlossene Fluidkreislauf damit so konfiguriert ist, dass es eine Reihenkühlung der Bauteile einer Elektronikkarte, die am meisten Wärme erzeugen, dann der anderen Bauteile der gleichen Elektronikkarte gibt.

2. System nach Anspruch 1, das eine Vielzahl von Elektronikkarten und eine Vielzahl von Wärmerohren enthält, wobei der geschlossene Fluidkreislauf damit so konfiguriert ist, dass es eine Reihenkühlung der Bauteile jeder der Elektronikkarten, die am meisten Wärme erzeugen, dann der anderen Bauteile der gleichen Elektronikkarte gibt.

3. System nach Anspruch 1 oder 2, wobei die Platinen aus Aluminium oder Kupfer sind.

4. System nach einem der Ansprüche 1 bis 3, wobei die Wärmerohre gepulst oder schwingend genannte Wärmerohre sind.

5. System nach einem der vorhergehenden Ansprüche, wobei die Wärmerohre eine Hülle enthalten, die aus einer Metallplatte besteht, in die eine Vielzahl von Kanälen eingeätzt ist, und die mit einer Verschluss-Metallplatte zusammengebaut ist, wobei die Kanäle mit dem Wärmerohrfluid gefüllt sind.

6. System nach einem der vorhergehenden Ansprüche, wobei die Wärmerohre eine Metallplatte enthalten, an der mit dem Wärmerohrfluid gefüllte Rohre befestigt sind.

7. System nach einem der Ansprüche 5 oder 6, wobei die Hüllen oder Rohre der Wärmerohre aus Kupfer mit Wasser gefüllt sind.

8. System nach einem der vorhergehenden Ansprüche, wobei der Verflüssiger der Wärmerohre oberhalb des Verdampfers der Wärmerohre angeordnet ist.

9. System nach einem der vorhergehenden Ansprüche, wobei die Elemente mit abgewickelter Fläche Lamellenkühlkörper sind.

10. System nach einem der vorhergehenden Ansprüche, wobei das dielektrische Öl ausgewählt wird aus einem Mineralöl, Silikon, auf der Basis von natürlichen Estern, auf der Basis von synthetischen Estern, auf der Basis von Fluorketon.

11. System nach einem der vorhergehenden Ansprüche, das ein Gehäuse enthält, in dessen Inneren der Behälter, die Pumpe, der Wasser-Öl-Tauscher und die Kanäle untergebracht sind.

12. Verwendung des Systems nach einem der vorhergehenden Ansprüche zur Durchführung der Erwärmung von Brauchwasser eines Gebäudes oder eines Schwimmbads, der Absorptionsklimatisierung, oder auch der thermischen Entsalzung mittels des Wasserkreislaufs des Tauschers.

## Claims

1. Cooling system (1) for cooling one or more computer servers and for producing heat from heat recovered from the server(s), comprising:
- a sealed vessel (2), filled with a dielectric oil;
- at least one electronic circuit board (3) supporting a plurality of electronic components, the electronic circuit board being arranged vertically inside the vessel between a lower portion and an upper portion of the vessel and being immersed in the dielectric oil;
- at least one plate comprising a heat pipe, of which the heating zone, called evaporator, is coupled thermally to one or more of the electronic components of one and the same circuit board which are the greatest generators of heat, while the cooling zone, called condenser, is arranged in the upper portion or the lower portion of the vessel, and preferably, an element with developed heat exchange surface fixed onto the condenser;
- a water/oil exchanger (7), arranged outside the vessel;
- an oil pump (5),
- a closed fluid circuit, containing the dielectric oil circulated by the oil pump, the closed circuit comprising, in fluidic series:
• one of the circuits, called oil circuit, of the exchanger,
• a duct (53) linking the oil circuit of the exchanger to the lower portion or the upper portion respectively of the interior of the first vessel,
• the interior of the vessel,
• at least one duct (50) linking the upper portion or the lower portion of the interior of the vessel to the oil circuit of the exchanger,
the closed fluid circuit being thus configured so as to have a series cooling of the components of an electronic circuit board that are the greatest generators of heat, then of the other components of the same electronic circuit board.

2. System according to Claim 1, comprising a plurality of electronic circuit boards and a plurality of heat pipes, the closed fluid circuit being thus configured so as to have a series cooling of the components of each of the electronic circuit boards that are the greatest generators of heat, then of the other components of the same electronic circuit board.

3. System according to Claim 1 or 2, the plates being made of aluminium or of copper.

4. System according to one of Claims 1 to 3, the heat pipes being heat pipes called pulsed or oscillating heat pipes.

5. System according to one of the preceding claims, the heat pipes comprising an enclosure composed of a metal plate etched with a plurality of channels and assembled with a closing metal plate, the channels being filled with the heat pipe fluid.

6. System according to one of the preceding claims, the heat pipes comprising a metal plate onto which tubes filled with the heat pipe fluid are fixed.

7. System according to one of Claims 5 and 6, the enclosures or tubes of the heat pipes being made of copper filled with water.

8. System according to one of the preceding claims, the condenser of the heat pipes being arranged above the evaporator of the heat pipes.

9. System according to one of the preceding claims, the elements with developed surface being finned heat sinks.

10. System according to one of the preceding claims, the dielectric oil being chosen from among a mineral oil, silicone, based on natural esters, based on synthetic esters, based on fluoroketone.

11. System according to one of the preceding claims, comprising a housing inside which are housed the vessel, the pump, the water/oil exchanger and the ducts.

12. Use of the system according to one of the preceding claims to perform the heating of the domestic supply water of a building or of a swimming pool, the absorption-based air conditioning, the thermal desalination, through the water circuit of the exchanger.
